# EUROPÄISCHE PATENTANMELDUNG

(11) **EP 2 624 453 A2**
(43) Veröffentlichungstag der Anmeldung: **07.08.2013**
(21) Anmeldenummer: 13000533.3
(22) Anmeldetag: 01.02.2013
(51) Int. Cl.: H03K 17/96

(54) **Vorrichtung zur Betätigung eines in oder an einem Körper angeordneten elektrischen Verbrauchers**

(30) Priorität: 03.02.2012 DE 102012001992; 23.02.2012 DE 102012003676
(71) Anmelder: Kesseböhmer Holding e.K., 49152 Bad Essen (DE)
(72) Erfinder: Barkau, Rene, 49179 Ostercappeln - Venne (DE); Baro, Dietmar, 49090 Osnabrück (DE)
(74) Vertreter: Pott, Ulrich

(57) **Zusammenfassung**

Die Erfindung bezieht sich auf eine Vorrichtung zur Betätigung eines in oder an einem Körper angeordneten elektrischen Verbrauchers, insbesondere eines in oder an einem Körper bewegbar abgestützten Gegenstandes, insbesondere zur Betätigung eines Möbel- und/oder Geräteteiles von Küchen- und Büromöbeln, Küchengeräten, Kücheneinbaugeräten, Warenausgabegeräten oder dgl. mit einem motorischen Antrieb zur Übertragung einer Öffnungs- und/oder Schließbewegung des Gegenstandes, der durch einen zumindest zwei voneinander getrennte Teile umfassenden Schalter aktivierbar ist. Um die Vorrichtung einfacher bedienbar zu machen und darüber hinaus Fehlauslösungen zu vermeiden ist vorgesehen, dass der Schalter als kapazitiver Näherungsschalter mit einer kapazitiven Sensorfläche 4 aus zumindest zwei sensitiven Segmenten 5 ausgebildet und mit einer Auswerteeinheit verbunden ist, die durch die Signale der zumindest zwei sensitiven Segmente 5 in Abhängigkeit der Betätigungsdauer, der Betätigungsreihenfolge und/oder des Betätigungsmusters der sensitiven Segmente 5 den gegenwärtigen Betriebszustand des elektrischen Verbrauchers regelt (Fig. 2).

## Beschreibung

Die Erfindung bezieht sich auf eine Vorrichtung zur Betätigung eines in oder an einem Körper angeordneten elektrischen Verbrauchers, insbesondere eines in oder an einem Körper bewegbar abgestützten Gegenstandes, vorzugsweise zur Betätigung eines Möbel- und/oder Geräteteiles von Küchen- und Büromöbeln, Küchengeräten, Kücheneinbaugeräten, Warenausgabegeräten oder dgl. mit einem motorischen Antrieb zur Übertragung einer Öffnungs- und/oder Schließbewegung des Gegenstandes, der durch einen zumindest zwei voneinander getrennte Teile umfassenden Schalter aktivierbar ist.

Vorrichtungen zur Betätigung eines bewegbar abgestützten Gegenstandes, beispielsweise in Gestalt eines in einem Möbelkorpus translatorisch bewegbaren Möbelteiles wie eine Schublade, einen Schrankauszug oder dgl. sind bekannt und haben beispielsweise einen an einer Frontblende angeordneten Schalter zum Aktivieren der Antriebsvorrichtung. Aus der WO 2006/017863 A1 ist eine solche Vorrichtung bekannt, bei der der Schalter wenigstens zwei baulich voneinander getrennte Teile umfasst. Ein erster Teil des Schalters ist an der Frontblende des bewegbaren Möbelteils angeordnet und ein zweiter Teil des Schalters ist im oder am Möbelkorpus angeordnet, wobei die manuelle Betätigung des ersten Teils des Schalters den zweiten Teil des Schalters betätigt, wonach die Signale des zweiten Teile des Schalters die Antriebsvorrichtung im Sinne einer Öffnungs- und/oder Schließbewegung des Gegenstandes aktiviert.

Nachteilig hierbei ist, dass der an der Frontblende des Möbelteils angeordnete erste Schalter eine sehr kleine Betätigungsfläche hat mit dem Nachteil, dass diese von der Bedienperson nur unzuverlässig sicher gefunden und damit betätigt werden kann. Dies ist insbesondere dann der Fall, wenn der erste Teil des Schalters für die Bedienperson von außen hier nicht sichtbar ist, so dass dies oftmals für den beabsichtigten Versuch, das Möbelteil zu öffnen, mehrere Öffnungsversuche erfordert, was für die Bedienperson außerordentlich nachteilig ist. Dies gilt auch, wenn als erstes Teil der Schaltvorrichtung beispielsweise ein kapazitiver Näherungsschalter Anwendung finden soll, der ebenfalls in herkömmlicher Ausbildung nur eine sehr kleine Betätigungsfläche hat. Hierbei ist ebenfalls nachteilig, dass eine versehentliche Auslösung kaum zu vermeiden ist, z.B. beim Reinigen eines entsprechenden Möbelteils, durch Flüssigkeitsspritzer, versehentliches Anlehnen, Vorbeistreichen und dgl.

Es ist Aufgabe der vorliegenden Erfindung, eine Vorrichtung der eingangs genannten Art dahingehend weiter zu bilden, dass eine möglichst sichere, einfache und komfortable Betätigung ermöglicht ist und ungewollte Fehlauslösungen zu vermeiden sind.

Zur Lösung dieser Aufgabe zeichnet sich die Vorrichtung der eingangs genannten Art dadurch aus, dass der Schalter als kapazitiver Näherungsschalter mit einer kapazitiven Sensorfläche aus zumindest zwei sensitiven Segmenten ausgebildet ist, wobei der Schalter mit einer Auswerteeinheit verbunden ist, die durch das Signal oder durch das Nichtsignal der zumindest zwei sensitiven Segmente in Abhängigkeit der Betätigungsdauer, der Betätigungsreihenfolge und/oder des Betätigungsmusters der sensitiven Segmente die Antriebsvorrichtung für eine Schließ- oder eine Öffnungsbewegung des Gegenstandes aktiviert. Als elektrische Verbraucher kommen z.B. Antriebsvorrichtungen für bewegbare Möbel- oder Geräteteile in Frage, aber auch zum Beispiel Leuchtkörper, Stromquellen, elektrische Schließvorrichtungen und dgl. mehr. Ein Schalter mit zwei voneinander getrennten Teilen kann auch ein Schalter mit zwei sensitiven Segmenten sein, die in einer Baueinheit zusammengefasst sind.

Damit ist eine Vorrichtung geschaffen, insbesondere eine Vorrichtung zur Betätigung eines Möbelteiles wie beispielsweise einer bewegbaren Schublade oder eines bewegbaren Möbelauszuges, bei der sicher und ohne ein großes Risiko von Fehlbetätigungen z.B. eine Antriebsvorrichtung für eine Schließ- oder eine Öffnungsbewegung aktiviert werden kann, indem aufgrund der Berührung oder der Annäherung an die zumindest zwei, vorzugsweise auch drei oder mehr sensitive Segmente die Betätigungsdauer, die Reihenfolge von z.B. über- oder nebeneinander oder diagonal angeordneten sensitiven Segmenten oder aber auch ein Betätigungsmuster, z.B. nach Art eines Zahlenschlosses, ausgewertet werden kann und als gültige Aktivierungs- bzw. Gestenerkennung genutzt wird zur Aktivierung bzw. Nichtaktivierung der Antriebsvorrichtung, je nach dem, ob eine gültige oder nicht gültige Gestenerkennung bzw. Berührungs- oder Annährungserkennung vorliegt.

Bei der erfindungsgemäßen Vorrichtung kann durch eine logische bzw. algorithmische Interpretation der Pegel der sensitiven Segmente die gewünschte Aktivierung und mithin Auslösung der Antriebsvorrichtung für eine Schließ- bzw. eine Öffnungsbewegung des Gegenstandes erfolgen. Dies kann durch eine Berührung mit einem Finger, der Hand, einem Arm und dgl. einer Bedienperson erfolgen. Die Empfindlichkeit der sensitiven Segmente bzw. des kapazitiven Näherungsschalters kann aber auch so eingestellt sein, dass auch bereits eine Annäherung mit einem Finger, einer Hand einem Arm oder dgl. ausreicht. Da dabei zweckmäßigerweise ein bestimmtes Muster wie beispielsweise die Zeitdauer oder die Betätigungsreihenfolge erfüllt sein muss, beispielsweise ein dynamisches oder statisches Muster, ist mithin ein versehentliche Auslösung z.B. bei Reinigungsarbeiten, einem Anlehnen an das Möbel, einen Vorbeistreichen an der Sensorfläche zu unterschieden von einer gültigen Erkennung. Ebenfalls lässt sich auf einfache Weise z.B. auch eine bewegungsgesteuerte Auswertung der Sensorfläche realisieren, wodurch sich auch eine Kindersicherung darstellen lässt. Dies lässt sich z.B. auch darstellen, indem eine bestimmte rechts/links- oder links/rechts-Bewegung Voraussetzung ist, um eine gültige Erkennung darzustellen. Gleiches gilt auch für eine Diagonalbewegung oder Bewegung von unten nach oben bzw. von oben nach unten oder auch für eine bestimmte Kombination (Zahlenschloss).

Ebenfalls lassen sich mit dieser Vorrichtung weitere Elemente steuern, z.B. auch für eine Beleuchtung eines Schrankes, indem Leuchtmittel ebenfalls durch den kapazitiven Näherungsschalter mit gesteuert werden können. Ebenfalls ist es möglich, z.B. bestimmte Gegenstände erst dann auszulösen, wenn in einer vorzugebenden und auch einzustellenden Betätigungsreihenfolge bestimmte sensitive Segmente ausgelöst werden, womit auch eine Schlossfunktion nach Art eines Zahlenschlosses zu realisieren ist. Zusätzlich besteht die Möglichkeit, auch noch sonstige Sensoren vorzusehen, auch beispielsweise Körperschallsensoren, um auch noch bestimmte Klopferkennungssignale zu erzeugen, die ebenfalls von der Auswärtseinheit erfasst werden können zwecks Aktivierung der Antriebsvorrichtung.

Weitere vorteilhafte Ausgestaltungen ergeben sich aus weiteren Unteransprüchen, der nachfolgenden Beschreibung und der Zeichnung. In der Zeichnung zeigt:
Fig. 1 in einer perspektivischen Darstellung mögliche Anwendbarkeiten eines Ausführungsbeispiels einer Vorrichtung nach der Erfindung in Gestalt a) eines Hochschrankes, b) eines Schrankmöbels, c) einer Eingangstür;
Fig. 2 ein Ausführungsbeispiel einer hinter einer Frontblende eines Möbels angeordneten kapazitiven Sensorfläche aus mehreren sensitiven Segmenten;
Fig. 3 Verschiedene Gestaltungen von Sensorflächen aus zumindest zwei sensitiven Segmenten;
Fig. 4 eine sensitive Fläche aus neun sensitiven Segmenten mit einer dar-unter dargestellten gültigen Multitouch-Gestenerkennung (oben: von links nach rechts, unten: von rechts nach links) und
Fig. 5 eine Sensorfläche mit zwei sensitiven Segmenten in horizontaler Anordnung mit einer darunter dargestellten gültigen Berührungser-kennung in Abhängigkeit der Zeit (t);

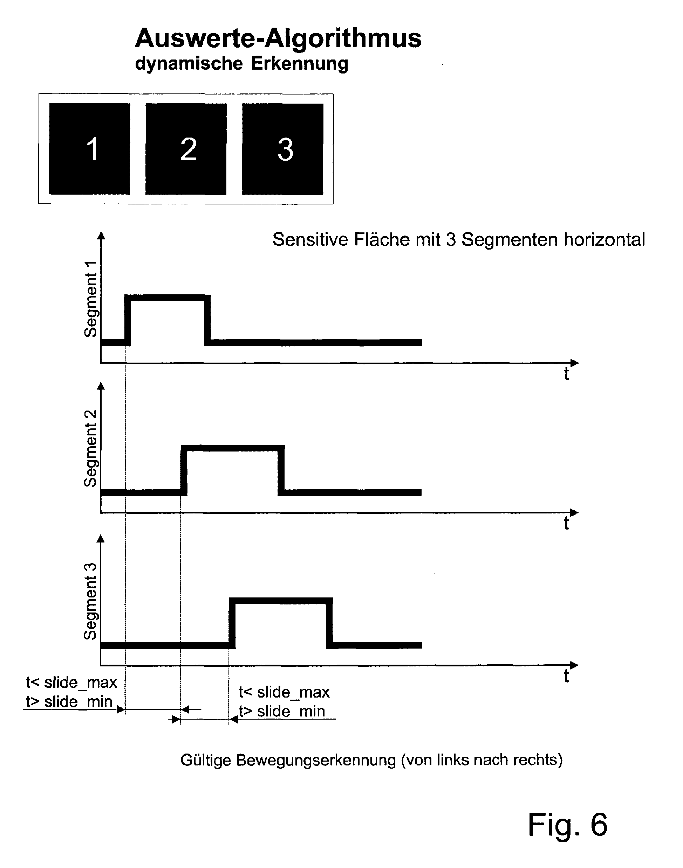

Fig. 6 Auswerte-Algorithmus (dynamische Erkennung);

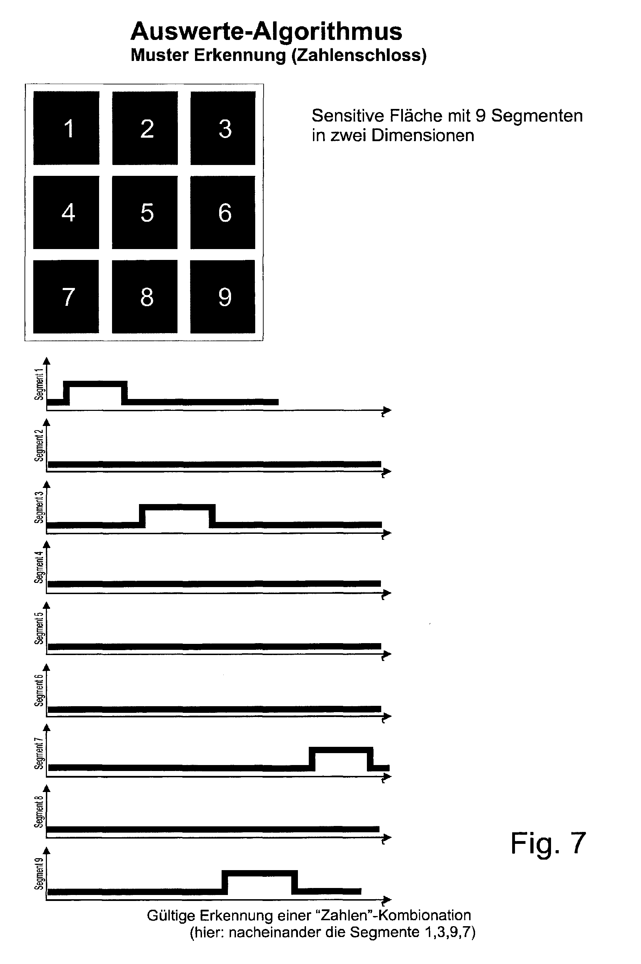

Fig. 7 Auswerte-Algorithmus (Muster Erkennung Zahlenschloss);

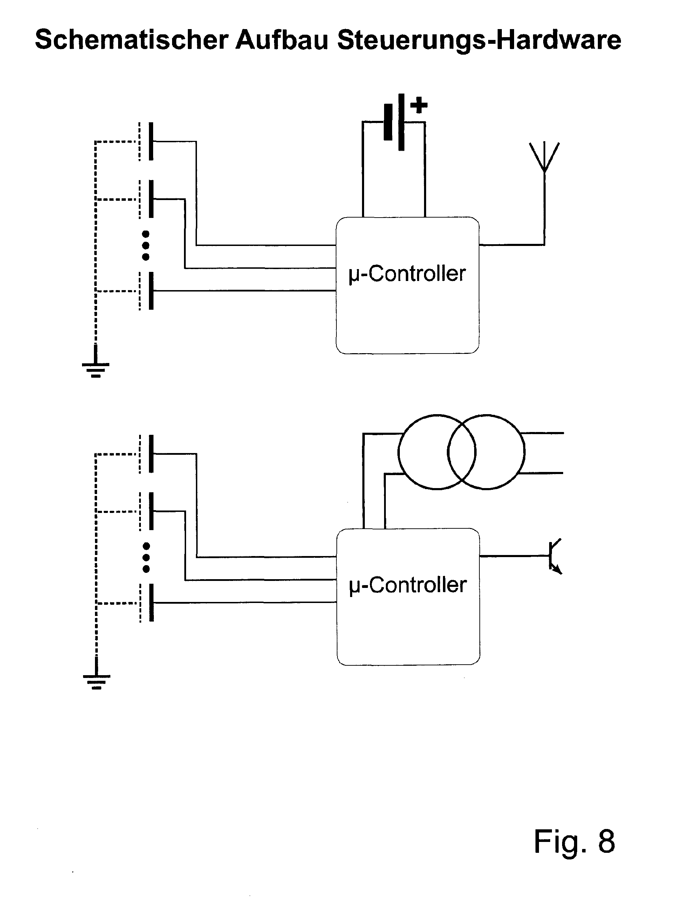

Fig. 8 Schematischer Aufbau Steuerungs-Hardware.

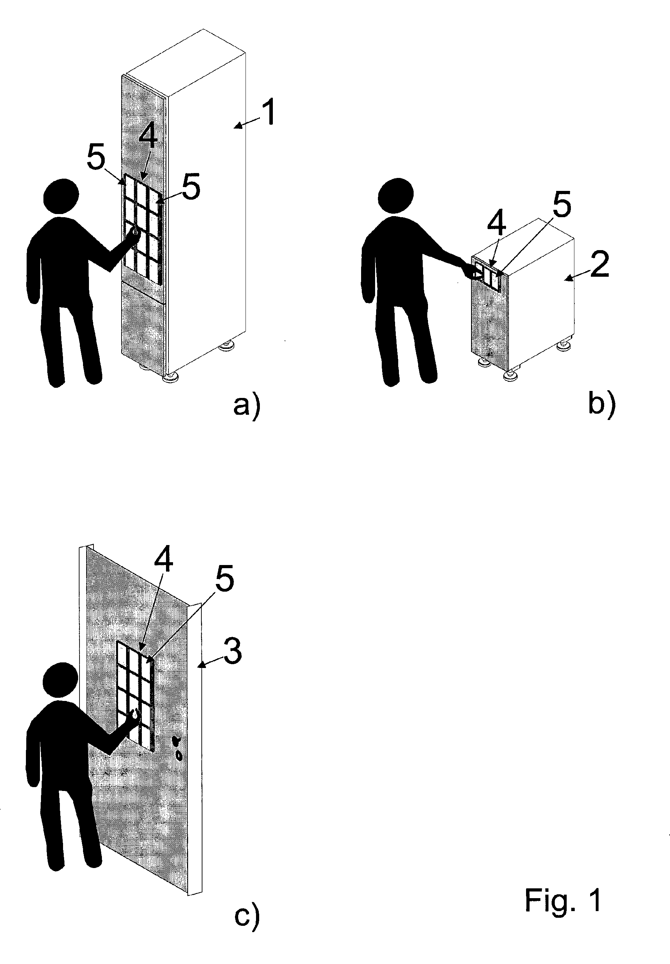

In der Zeichnung sind gleichwirkende Teile mit übereinstimmenden Bezugsziffern versehen. In dem Ausführungsbeispiel nach Fig. 1 ist ein höheres Schrankmöbel 1 (Fig. 1a), ein kleineres Schrankmöbel 2 (Fig. 1b) und eine Eingangstür 3 (Fig. 1c) dargestellt. In der jeweiligen Frontfläche des Schrankes 1, 2 bzw. der Tür 3 ist eine Sensorfläche 4 aus mehreren sensitiven Segmenten 5 vorgesehen, die mit einer nicht näher dargestellten Auswerteeinheit in Verbindung (z.B. drahtgebunden, drahtlose, Funk) stehen, die mit einer Antriebsvorrichtung verbunden ist, die bei einer gültigen Mustererkennung der berührten oder angenäherten sensitiven Segmente 5 die Tür 3 bzw. den entsprechenden Auszug des Schrankes 1, 2 im Öffnungs- oder Schließsinne betätigt.

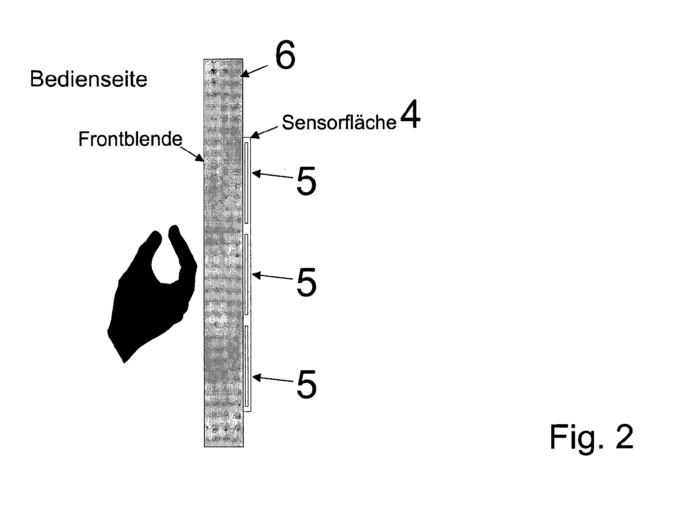

In dem Ausführungsbeispiel nach Fig. 2 ist eine Frontblende 6 einer Schublade eines Möbels gezeigt, bei der hinter der vorderseitigen Frontblende 6 die Sensorfläche 4 vorgesehen ist mit den sensitiven Segmenten 5, die bei statischer Berührung, Annäherung, Überstreichen je nach der gültigen Gestenerkennung oder Betätigung nach gültigem Muster Signale zu der nicht gezeigten Auswerteeinheit liefert, die bei gültiger Erkennung die Antriebsvorrichtung in einem Öffnungs- bzw. Schließsinn bzw. einen anderen elektrischen Verbraucher aktiviert.

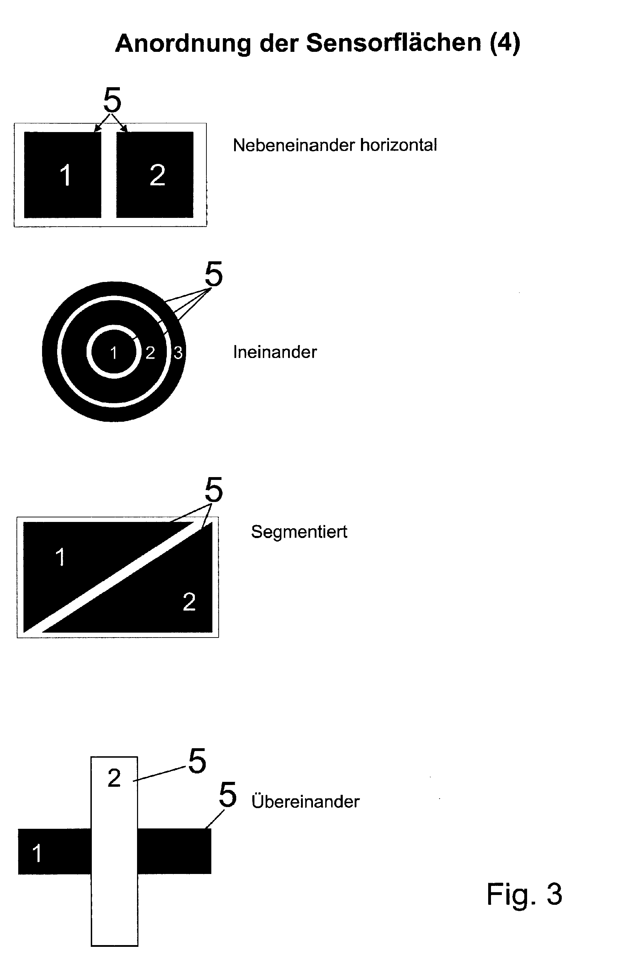

In der Fig. 3 sind verschiedene Sensorflächen 4 dargestellt, nämlich einmal mit zwei nebeneinander angeordneten sensitiven Segmenten 5, darunter drei ringförmige ineinandergeschachtelte sensitive Segmente 5, als drittens in der Reihenfolge von oben nach unten zwei dreieckförmige sensitive Segmente 5 und unten zwei übereinander und kreuzförmig angeordnete sensitive Segmente 5.

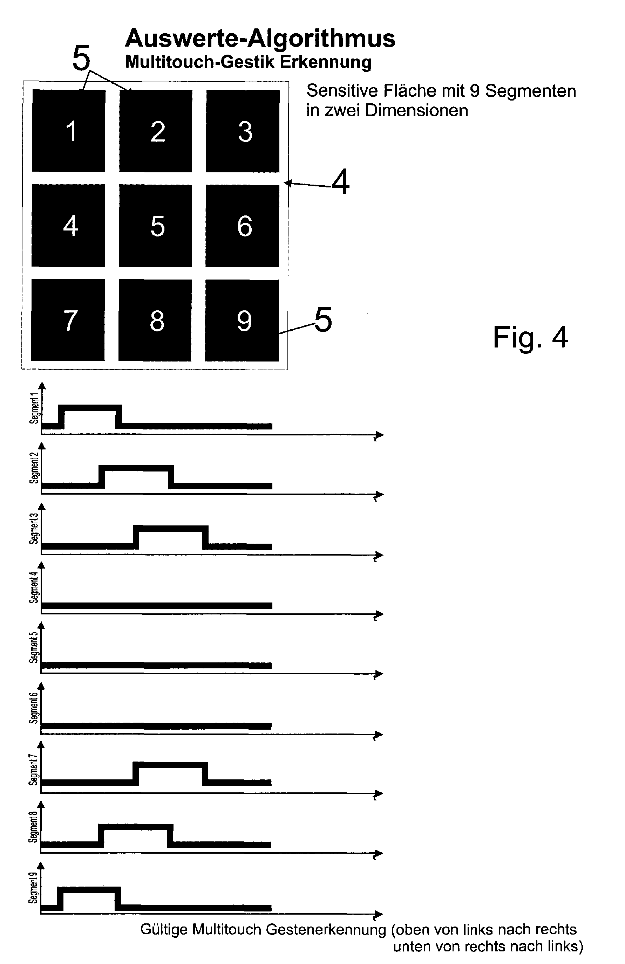

In Fig. 4 sind insgesamt neun sensitive Segmente 5 vorgesehen und zwar jeweils drei Reihen übereinander, bestehend aus jeweils drei sensitiven Segmenten 5. Unten ist ein Beispiel für eine gültige Multitouchgestenerkennung dargestellt, wobei zeitgleich in der ersten Reihe eine Berührung in bestimmten Zeitintervallen nacheinander von links nach rechts zu erfolgen hat und zeitgleich den bestimmten Zeitintervallen und eine Reihenfolge von rechts nach links in der unteren Reihe, also beginnend mit dem ersten und dem neunten sensitiven Segment 5. Erst wenn dieses Muster dargestellt ist, erkennt die Auswerteeinheit die gültige Mustererkennung, so dass die Antriebsvorrichtung im Öffnungs- oder Schließsinne aktiviert werden kann.

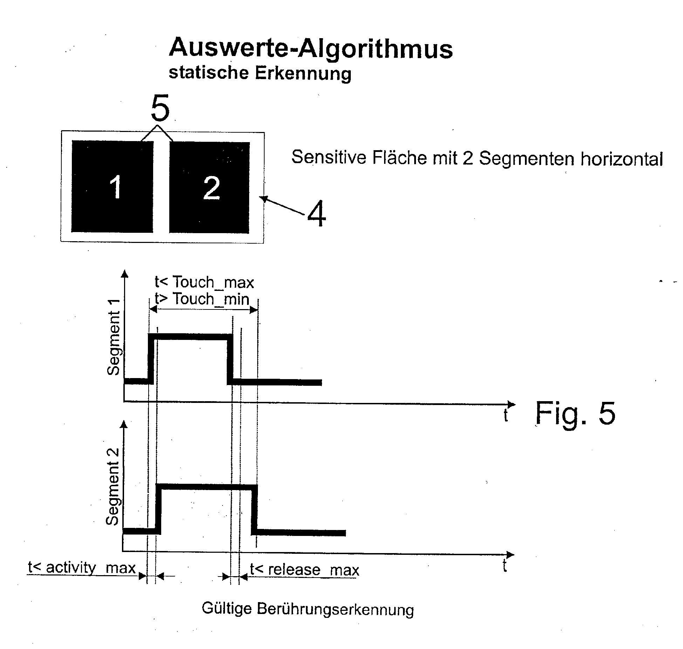

In Fig. 5 ist eine analoge Darstellung eines alternativen Ausführungsbeispiels gezeigt mit zwei sensitiven Segmenten 5 der Sensorfläche 4 mit einer gültigen Erkennung von links nach rechts.

## Patentansprüche

1. Vorrichtung zur Betätigung eines in oder an einem Körper angeordneten elektrischen Verbrauchers, insbesondere eines in oder an einem Körper bewegbar abgestützten Gegenstandes, vorzugsweise zur Betätigung eines Möbel- und/oder Geräteteiles von Küchen- und Büromöbeln, Küchengeräten, Kücheneinbaugeräten, Warenausgabegeräten oder dgl. mit einem motorischen Antrieb zur Übertragung einer Öffnungs- und/oder Schließbewegung des Gegenstandes, der durch einen zumindest zwei voneinander getrennte Teile umfassenden Schalter aktivierbar ist, **dadurch gekennzeichnet, dass** der Schalter als kapazitiver Näherungsschalter mit einer kapazitiven Sensorfläche (4) aus zumindest zwei sensitiven Segmenten (5) ausgebildet, und mit einer Auswerteeinheit verbunden ist, die durch die Signale der zumindest zwei sensitiven Segmente (5) den gegenwärtigen Betriebszustand des elektrischen Verbrauchers regelt.

2. Vorrichtung nach Anspruch 1, **dadurch gekennzeichnet, dass** der kapazitive Näherungsschalter eine Sensorfläche (4) mit zumindest drei nebeneinander ineinander und/oder übereinander angeordneten sensitiven Segmenten aufweist.

3. Vorrichtung nach Anspruch 1 oder 2, **dadurch gekennzeichnet, dass** der kapazitive Näherungsschalter zumindest drei übereinander angeordneten Reihen aus jeweils drei sensitiven Segmenten (5) aufweist.

4. Vorrichtung nach einem der Ansprüche 1 bis 3, **dadurch gekennzeichnet, dass** für eine gültige Bewegungserkennung zur Aktivierung des elektrischen Verbrauchers die Berührungszeit von nacheinander berührten oder angenäherten sensitiven Segmenten (5) der Sensorfläche (4) des kapazitiven Näherungsschalter in der Auswerteeinheit ausgewertet wird und erst bei Überschreiten einer vorgebbaren Berührungsdauer und bei Vorlegen einer Überlappung der Berührungszeiten eine gültige Bewegungserkennung zur Aktivierung der Antriebsvorrichtung erzeugt wird.

5. Vorrichtung nach einem der Ansprüche 1 bis 4, **dadurch gekennzeichnet, dass** die Auswerteeinheit dem elektrischen Verbraucher erst ein Betätigungssignal übermittelt, wenn zwischen der Betätigung des ersten sensitiven Segmentes (5) und der Betätigung oder Nichtbetätigung eines weiteren sensitiven Segmentes (5) maximal die Zeitaktivität (activity max.) betragen hat, und die Zeit zwischen dem Verlassen eines betätigten sensitiven Segmentes (5) und aller weiteren betätigten oder nicht betätigten sensitiven Segmente (5) maximal die Zeit (release max.) betragen hat, die Gesamtbetätigungsdauer (maximal) die Zeit (touch max.) betragen hat und die Betätigungsdauer des oder der vorgesehenen sensitiven Segmente(s) mindestens der Zeit (touch min.) entsprochen hat.

6. Vorrichtung nach Anspruch 5, **dadurch gekennzeichnet, dass** die Auslöseeinheit erst ein Aktivierungssignal an den elektrischen Verbraucher übermittelt, wenn sensitive Segmente (5) in einem vorgebbar auswählbaren Zusammenhang betätigt werden.

7. Vorrichtung nach Anspruch 6, **dadurch gekennzeichnet, dass** die Auswerteeinheit erst ein Aktivierungssignal an den elektrischen Verbraucher übermittelt, wenn sensitive Segmente (5) in einer bestimmten Reihenfolge betätigt wird.

8. Vorrichtung nach Anspruch 7, **dadurch gekennzeichnet, dass** die nacheinander betätigten Segmente (5) nebeneinander und/oder übereinander angeordnet sind.

9. Vorrichtung nach einem der Ansprüche 5 bis 8, **dadurch gekennzeichnet, dass** die Betätigung des ersten sensitiven Segmentes (5) und des weiteren sensitiven Segmentes (5) maximal der Zeit (touch max.) entspricht.

10. Vorrichtung nach einem der Ansprüche 5 bis 9, **dadurch gekennzeichnet, dass** die Aufhebung der Betätigung des ersten sensitiven Segmentes (5) und ggf. eines weiteren sensitiven Segmentes (5) für eine Aktivierung des elektrischen Verbrauchers innerhalb einer vorgebbaren Zeit (release max.) erfolgen muss.

11. Vorrichtung nach einem der Ansprüche 1 bis 10, **dadurch gekennzeichnet, dass** die Auslöseeinheit den elektrischen Verbraucher erst dann aktiviert, wenn ein sensitives Segment (5) oder mehrere sensitive Segmente (5) in einer vorgebbaren Reihenfolge mehrfach betätigt werden.

12. Vorrichtung nach Anspruch 11, **dadurch gekennzeichnet, dass** die Mehrfachbetätigung innerhalb eines vorgebbaren Zeitfensters erfolgen muss.

13. Vorrichtung nach einem der Ansprüche 1 bis 12, **dadurch gekennzeichnet, dass** die kapazitive Sensorfläche (4) aus mindestens zwei sensitiven Segmenten (5) selbstkalibrierend ausgebildet ist.

14. Vorrichtung nach einem der Ansprüche 1 bis 13, **dadurch gekennzeichnet, dass** die kapazitive Sensorflächen (4) aus mindestens zwei sensitiven Segmenten (5) an oder in einer Frontblende, einer Tür oder einer Gerätefront oder einer separaten Einheit angeordnet ist.

15. Vorrichtung nach einem der Ansprüche 1 bis 14, **dadurch gekennzeichnet, dass** die Empfindlichkeit der sensitiven Segmente (5) der kapazitiven Sensorfläche (4) einstellbar ausgebildet ist.

16. Vorrichtung nach einem der Ansprüche 1 bis 15, **dadurch gekennzeichnet, dass** die kapazitive Sensorfläche (4) aus mindestens zwei sensitiven Segmenten (5) derart ausgebildet ist, dass sie nur bei Berührung oder schon bei Annäherung reagiert.
